# EUROPÄISCHE PATENTANMELDUNG

(11) **EP 3 474 641 A1**
(43) Veröffentlichungstag der Anmeldung: **24.04.2019**
(21) Anmeldenummer: 17197821.6
(22) Anmeldetag: 23.10.2017
(51) Int. Cl.: H05K 3/28, C09D 11/101, C09D 11/30, G03F 7/028, H05K 3/34, C08L 63/00

(54) **LÖTSTOPPLACK ZUM AUFBRINGEN MITTELS TINTENSTRAHLTECHNOLOGIE**

(71) Anmelder: Peters Research GmbH & Co. Kommanditgesellschaft, 47906 Kempen (DE)
(72) Erfinder: Schwartz, Ralf, 47906 Kempen (DE); Tekath, Johannes, 48653 Coesfeld (DE)
(74) Vertreter: Dr. Stark & Partner Patentanwälte mbB

(57) **Zusammenfassung**

Die Erfindung betrifft einen Lötstopplack zum Aufbringen mittels Tintenstrahltechnologie, wobei die Zusammensetzung des Lötstopplacks eine Wärmebeständigkeit für ein Tintenstrahlsystem besitzt.

Um einen Lötstopplack anzugeben, mit dem kostengünstig und ressourcenschonend auch feinere Strukturen, teilweise von < 50 µm, realisierbar sind, soll die Zusammensetzung wenigstens folgende Komponenten umfassen:
- zumindest ein Monomer mit wenigstens einer kationisch härtbaren Gruppe und/oder zumindest ein Oligomer mit wenigstens einer kationisch härtbaren Gruppe,
- zumindest ein Monomer mit wenigstens einer radikalisch härtbaren Gruppe und/oder zumindest ein Oligomer mit wenigstens einer radikalisch härtbaren Gruppe,
- zumindest ein Monomer mit wenigstens einer thermisch härtbaren Gruppe und/oder zumindest ein Oligomer mit wenigstens einer thermisch härtbaren Gruppe,
- mindestens einen radikalisch initiierenden Fotopolymerisationsinitiator und
- mindestens einen kationisch initiierenden Fotopolymerisationsinitiator.

## Beschreibung

Die Erfindung betrifft einen Lötstopplack zum Aufbringen mittels Tintenstrahltechnologie, wobei die Zusammensetzung des Lötstopplacks eine Wärmebeständigkeit für ein Tintenstrahlsystem besitzt.

Aus der Praxis sind derartige Lötstopplacke bekannt, die mittels Tintenstrahldruckverfahren strukturiert auf Leiterplatten für elektronische Schaltungen appliziert werden. Diese Lötstopplacke erfüllen auf einer Leiterplatte mehrere verschiedene Funktionen. Zum einen wird hierdurch ein Schutz der Leiterplatte vor Korrosion und mechanischen Beschädigungen bewirkt. Zum anderen verhindert der Lötstopplack beim Löten das Benetzen der Leiterplatte mit dem Lot in denjenigen Bereichen der Leiterplatte, die mit dem Lötstopplack überzogenen sind. Auch werden durch den Lötstopplack elektrische Eigenschaften wie beispielsweise die Durchschlagsfestigkeit verbessert.

Die aus der Praxis bekannten Lötstopplacke werden üblicherweise mittels Sieb- oder Schablonendruckverfahren in der gewünschten Struktur auf die Außenlagen gedruckter elektronischer Schaltungen auf einer Leiterplatte gedruckt. Dabei ist jedoch von Nachteil, dass mittels Siebdruckverfahren nur eine Darstellung von relativ groben Strukturen von > 200 µm möglich ist.

Die für Sieb- oder Schablonendruckverfahren verwendeten Lötstopplacke basieren beispielsweise auf Bindemitteln aus der Gruppe der Epoxi-Novolake und umfassen auch geeignete Härter, beispielsweise aus der Gruppe der Amine, so dass die Lötstopplacke mittels thermischer Behandlung zu einem thermisch stabilen und chemikalienfesten Lackfilm vernetzbar sind.

Eine andere Art solcher Lötstopplacke basiert auf UV-härtbaren Oligomeren und Monomeren mit acryloylfunktionellen Gruppen. Hierbei erfolgt die Vernetzung mittels UV-Strahlung, durch die in dem Lötstopplack vorhandene geeignete Fotoinitiatoren eine radikalische Polymerisation initiieren.

Auch sind sogenannte fotostrukturierbare Lötstopplacke bekannt, bei denen nach physikalischer Trocknung des Lackfilmes die Strukturierung durch einen strukturgebenden Belichtungsvorgang mit anschließendem Entwicklungsprozess erfolgt. Dabei erfolgt die Beschichtung vollflächig mittels Siebdruck, Vorhanggießverfahren oder Sprühapplikation. Mit diesem Verfahren können auch feinere Strukturen, teilweise von < 50 µm, realisiert werden. Allerdings sind diese Verfahren recht aufwändig, weil neben dem Auftragsverfahren und der Trocknung zumindest ein Entwicklungsprozess erforderlich ist, um die unbelichteten Bereiche freizustellen. Weiterhin nachteilig ist, dass dieser Entwicklungsprozess in Lösemitteln oder in alkalischen Medien erfolgt, wobei das Entwicklermedium anschließend aufwendig aufbereitet oder entsorgt werden muss. Zudem wird bei solchen Verfahren ein Anteil des Lacks abentwickelt und verbleibt somit nicht funktionell auf der Leiterplatte, was sowohl hinsichtlich der Kosten als auch in Bezug auf Ressourcen und die Umwelt negativ zu beurteilen ist.

Für das direkte Erzeugen feinster Lackstrukturen bietet sich das Tintenstrahldruckverfahren mittels eines Tintenstrahlsystems an. Hierfür muss der Lötstopplack eine deutlich niedrigere Viskosität aufweisen, da die Verwendung der klassischen höhermolekularen Harze die Mitverwendung größerer Lösemittelmengen erforderlich machen würde, was sich nachteilig auf den Festkörper sowie die erzielbare Trockenschicht und damit auch auf die Prozessgeschwindigkeit und die Strukturgenauigkeit auswirken würde.

Auch würde die Möglichkeit bestehen, die Temperatur des Lötstopplacks beim Drucken zu erhöhen und hierdurch eine Viskositätserniedrigung zu erreichen, woraus jedoch eine deutliche Einschränkung der geeigneten Zusammensetzung resultiert, da viele Komponenten in Kombination mit anderen notwendigen Bestandteilen der Zusammensetzung nicht ausreichend temperaturstabil sind.

Aufgabe der Erfindung ist es, die vorgenannten Nachteile zu vermeiden und einen Lötstopplack anzugeben, mit dem kostengünstig und ressourcenschonend auch feinere Strukturen, teilweise von < 50 µm, realisierbar sind.

Diese Aufgabe wird bei einem gattungsgemäßen Lötstopplack dadurch gelöst, dass die Zusammensetzung wenigstens folgende Komponenten umfasst:
- zumindest ein Monomer mit wenigstens einer kationisch härtbaren Gruppe und/oder zumindest ein Oligomer mit wenigstens einer kationisch härtbaren Gruppe,
- zumindest ein Monomer mit wenigstens einer radikalisch härtbaren Gruppe und/oder zumindest ein Oligomer mit wenigstens einer radikalisch härtbaren Gruppe,
- zumindest ein Monomer mit wenigstens einer thermisch härtbaren Gruppe und/oder zumindest ein Oligomer mit wenigstens einer thermisch härtbaren Gruppe,
- mindestens einen radikalisch initiierenden Fotopolymerisationsinitiator und
- mindestens einen kationisch initiierenden Fotopolymerisationsinitiator.

Insoweit erlaubt die Verwendung niedrigviskoser niedermolekularer UVhärtbarer Monomere, Dimere oder anderer Oligomere den weitgehenden Verzicht auf flüchtige Verdünnungen wie auch eine Reduzierung solcher Reaktiv-Verdünnungen.

Durch die UV-Härtung ist eine sehr schnelle Polymerisation und damit eine Fixierung des Lackes möglich. Somit können feinste Strukturen gut dargestellt werden, da die Lacktropfen unmittelbar nach dem Auftreffen auf das Substrat schnell fixiert werden und nicht aufgrund ihrer niedrigen Viskosität zu stark verlaufen.

Die typischerweise eingesetzten UV-härtbaren Lacke benötigen zusätzlich zur UV-Vernetzung noch eine weitere thermische Vernetzung. Da die Polymerisierung von Monomeren durch UV-Strahlen jedoch lediglich relativ schwach vernetzte Filme ergibt, sind die erforderlichen Eigenschaften eines Lötstopplacks, wie thermische Beständigkeit und Chemikalienbeständigkeit, nicht gegeben. Demgegenüber benötigt die erfindungsgemäße Zusammensetzung nur wenig thermische Vernetzung. Die Vernetzung erfolgt im Wesentlichen durch Strahlenhärtung.

Vorzugsweise kann zumindest ein Oligomer mit wenigstens einer kationisch härtbaren Gruppe als ein Dimer ausgebildet sein.

Weiterhin kann zumindest ein Oligomer mit wenigstens einer radikalisch härtbaren Gruppe als ein Dimer ausgebildet sein.

Auch kann zumindest ein Oligomer mit wenigstens einer thermisch härtbaren Gruppe als ein Dimer ausgebildet sein.

Erfindungsgemäß kann eine kationisch härtbare Gruppe ausgewählt sein aus einer Gruppe, welche die cycloaliphatischen Epoxide und die Vinylether umfasst.

Vorzugsweise kann zumindest eine radikalisch härtbare Gruppe ausgewählt sein aus einer Gruppe, welche die Acrylatester, die Methacrylatester und die Vinylether umfasst.

Weiterhin kann zumindest eine thermisch härtbare Gruppe ausgewählt sein aus einer Gruppe, welche die Epoxide, die Polyole und die stickstoffhaltigen reaktiven Gruppen umfasst.

Auch kann die Zusammensetzung Moleküle umfassen, in denen jeweils zumindest eine kationisch härtbare Komponente und wenigstens eine radikalisch härtbare Komponente gemeinsam vorhanden sind.

Bei einem bevorzugten Ausführungsbeispiel der Erfindung kann die Gesamtheit einer kationisch härtbaren Komponente und die Gesamtheit einer radikalisch härtbaren Komponente in entsprechenden Molekülen zusammen vorhanden sein. Alternativ kann der Anteil einer kationisch härtbaren Komponente und der Anteil einer radikalisch härtbaren Komponente, die in entsprechenden Molekülen zusammen vorhanden sind, auch 5 Gew.% bis 30 Gew.%, vorzugsweise 15 Gew.% betragen.

Erfindungsgemäß können die einzelnen Komponenten der Zusammensetzung derart ausgewählt und ausgebildet sein, dass der Lötstopplack beim Aushärten ein interpenetrierendes Netzwerk, bestehend aus mindestens zwei Netzwerken, ausbildet.

Die Verwendung von sowohl kationischen als auch radikalischen Fotopolymerisationsinitiatoren führt in einem ersten Aushärtungsschritt zu einer Ausbildung eines sogenannten interpenetrierenden Netzwerkes, wodurch sowohl die Lötstopplackeigenschaften verbessert und weiterhin auch Vorteile in den mechanischen Eigenschaften, wie Versprödungsbeständigkeit und Elastizitäten, im Vergleich zu einem einheitlichen Netzwerk, erreicht werden. Weiterhin sind auf diese Weise ausreichend niedrige Viskositäten, im Temperaturbereich von 20 °C bis 35 °C, erreichbar.

Die Volumenkontraktion, die bei einer rein radikalischen Polymerisation auftritt und bei 5 Gew.% bis 15 Gew.% liegen kann, wird durch die Kombination der beiden Härtungsmechanismen (radikalisch und kationisch) und Ausbildung des interpenetrierenden Netzwerkes verringert und führt somit zu einer besseren Haftung, insbesondere auf metallischen und anderen kritischen Untergründen.

Vorzugsweise kann die Viskosität der Zusammensetzung (bei 20°C) 10 mPas bis 50 mPas, vorzugsweise 19 mPas, betragen, so dass eine ausreichende Viskosität für den Einsatz in einem Tintenstrahlsystem zum Aufbringen mittels Tintenstrahltechnologie gegeben ist.

Erfindungsgemäß kann der Anteil des zumindest einen Monomers mit wenigstens einer kationisch härtbaren Gruppe und/oder der Anteil des zumindest einen Oligomers mit wenigstens einer kationisch härtbaren Gruppe an der Zusammensetzung insgesamt 10 Gew.% bis 50 Gew.%, vorzugsweise 28 Gew.%, betragen.

Auch kann der Anteil des zumindest einen Monomers mit wenigstens einer radikalisch härtbaren Gruppe und/oder der Anteil des zumindest einen Oligomers mit wenigstens einer radikalisch härtbaren Gruppe an der Zusammensetzung insgesamt 10 Gew.% bis 70 Gew.%, vorzugsweise 35 Gew.%, betragen.

Weiterhin kann der Anteil des zumindest einen Monomers mit wenigstens einer kationisch härtbaren Gruppe und/oder der Anteil des zumindest einen Oligomers mit wenigstens einer thermisch kationisch härtbaren Gruppe an der Zusammensetzung insgesamt 5 Gew.% bis 30 Gew.%, vorzugsweise 14 Gew.%, betragen.

Vorzugsweise kann der Anteil des zumindest einen radikalisch initiierenden Fotopolymerisationsinitiator an der Zusammensetzung insgesamt 1 Gew.% bis 5 Gew.%, vorzugsweise 3 Gew.%, betragen.

Erfindungsgemäß kann der Anteil des zumindest einen kationisch initiierenden Fotopolymerisationsinitiator an der Zusammensetzung insgesamt 1 Gew.% bis 5 Gew.%, vorzugsweise 2,5 Gew.%, betragen.

Vorzugsweise kann die Zusammensetzung weiterhin 0,5 Gew.% bis 5 Gew.%, vorzugsweise 1,5 Gew.%, Pigmente und/oder Farbstoffe umfassen.

Auch kann die Zusammensetzung weiterhin 1 Gew.% bis 5 Gew.%, vorzugsweise 1,5 Gew.%, Additive, wie z. B. Lackadditive wie beispielsweise Netz- und Dispergierhilfsmittel, Entschäumer oder Mittel zur Reduktion der Oberflächenspannung, und/oder Füllstoffe umfassen.

Bevorzugt kann die Zusammensetzung und damit das so erhaltene interpenetrierende Netzwerk mit weiteren thermisch härtbaren Monomeren und/oder Oligomeren, vorzugsweise Dimeren, versehen sein und somit mittels einer nachträglich durchgeführten thermischen Härtung eine weitere Erhöhung der Netzwerkdichte und bessere Haftung bewirken.

Die thermische Aushärtung kann dabei bei mindestens 120 °C und bevorzugt bei 150°C erfolgen und mittels einer gesteigerten Reaktionsgeschwindigkeit die zuvor durch UV-Strahlung initierte Vernetzung weiterführen und zu einer Vernetzung der thermisch härtbaren Epoxygruppen, mit Hilfe der durch die UV-Bestrahlung der kationischen Fotopolymerisation gebildeten Kationen, führen.

## Patentansprüche

1. Lötstopplack zum Aufbringen mittels Tintenstrahltechnologie, wobei die Zusammensetzung des Lötstopplacks eine Wärmebeständigkeit für ein Tintenstrahlsystem besitzt, **dadurch gekennzeichnet, dass** die Zusammensetzung wenigstens folgende Komponenten umfasst:
- zumindest ein Monomer mit wenigstens einer kationisch härtbaren Gruppe und/oder zumindest ein Oligomer mit wenigstens einer kationisch härtbaren Gruppe,
- zumindest ein Monomer mit wenigstens einer radikalisch härtbaren Gruppe und/oder zumindest ein Oligomer mit wenigstens einer radikalisch härtbaren Gruppe,
- zumindest ein Monomer mit wenigstens einer thermisch härtbaren Gruppe und/oder zumindest ein Oligomer mit wenigstens einer thermisch härtbaren Gruppe,
- mindestens einen radikalisch initiierenden Fotopolymerisationsinitiator und
- mindestens einen kationisch initiierenden Fotopolymerisationsinitiator.

2. Lötstopplack nach dem vorhergehenden Anspruch, **dadurch gekennzeichnet, dass** zumindest ein Oligomer mit wenigstens einer kationisch härtbaren Gruppe als ein Dimer ausgebildet ist.

3. Lötstopplack nach einem der vorhergehenden Ansprüche, **dadurch gekennzeichnet, dass** zumindest ein Oligomer mit wenigstens einer radikalisch härtbaren Gruppe als ein Dimer ausgebildet ist.

4. Lötstopplack nach einem der vorhergehenden Ansprüche, **dadurch gekennzeichnet, dass** zumindest ein Oligomer mit wenigstens einer thermisch härtbaren Gruppe als ein Dimer ausgebildet ist.

5. Lötstopplack nach einem der vorhergehenden Ansprüche, **dadurch gekennzeichnet, dass** zumindest eine kationisch härtbare Gruppe ausgewählt ist aus einer Gruppe, welche die cycloaliphatischen Epoxide und die Vinylether umfasst.

6. Lötstopplack nach einem der vorhergehenden Ansprüche, **dadurch gekennzeichnet, dass** zumindest eine radikalisch härtbare Gruppe ausgewählt ist aus einer Gruppe, welche die Acrylatester, die Methacrylatester und die Vinylether umfasst.

7. Lötstopplack nach einem der vorhergehenden Ansprüche, **dadurch gekennzeichnet, dass** zumindest eine thermisch härtbare Gruppe ausgewählt ist aus einer Gruppe, welche die Epoxide, die Polyole und die stickstoffhaltigen reaktiven Gruppen umfasst.

8. Lötstopplack nach einem der vorhergehenden Ansprüche, **dadurch gekennzeichnet, dass** die Zusammensetzung Moleküle umfasst, in denen jeweils zumindest eine kationisch härtbare Komponente und wenigstens eine radikalisch härtbare Komponente gemeinsam vorhanden sind.

9. Lötstopplack nach dem vorhergehenden Anspruch, **dadurch gekennzeichnet, dass** die Gesamtheit einer kationisch härtbaren Komponente und die Gesamtheit einer radikalisch härtbaren Komponente in entsprechenden Molekülen zusammen vorhanden sind.

10. Lötstopplack nach einem der vorhergehenden Ansprüche, **dadurch gekennzeichnet, dass** die einzelnen Komponenten der Zusammensetzung derart ausgewählt und ausgebildet sind, dass der Lötstopplack beim Aushärten ein interpenetrierendes Netzwerk, bestehend aus mindestens zwei Netzwerken, ausbildet.

11. Lötstopplack nach einem der vorhergehenden Ansprüche, **dadurch gekennzeichnet, dass** die Viskosität der Zusammensetzung (bei 20°C) 10 mPas bis 50 mPas, vorzugsweise 19 mPas, beträgt.

12. Lötstopplack nach einem der vorhergehenden Ansprüche, **dadurch gekennzeichnet, dass** der Anteil des zumindest einen Monomers mit wenigstens einer kationisch härtbaren Gruppe und/oder der Anteil des zumindest einen Oligomers mit wenigstens einer kationisch härtbaren Gruppe an der Zusammensetzung insgesamt 10 Gew.% bis 50 Gew.%, vorzugsweise 28 Gew.%, beträgt.

13. Lötstopplack nach einem der vorhergehenden Ansprüche, **dadurch gekennzeichnet, dass** der Anteil des zumindest einen Monomers mit wenigstens einer radikalisch härtbaren Gruppe und/oder der Anteil des zumindest einen Oligomers mit wenigstens einer radikalisch härtbaren Gruppe an der Zusammensetzung insgesamt 10 Gew.% bis 70 Gew.%, vorzugsweise 35 Gew.%, beträgt.

14. Lötstopplack nach einem der vorhergehenden Ansprüche, **dadurch gekennzeichnet, dass** der Anteil des zumindest einen Monomers mit wenigstens einer kationisch härtbaren Gruppe und/oder der Anteil des zumindest einen Oligomers mit wenigstens einer kationisch härtbaren Gruppe an der Zusammensetzung insgesamt 5 Gew.% bis 30 Gew.%, vorzugsweise 14 Gew.%, beträgt.

15. Lötstopplack nach einem der vorhergehenden Ansprüche, **dadurch gekennzeichnet, dass** der Anteil des zumindest einen radikalisch initiierenden Fotopolymerisationsinitiator an der Zusammensetzung insgesamt 1 Gew.% bis 5 Gew.%, vorzugsweise 3 Gew.%, beträgt.

16. Lötstopplack nach einem der vorhergehenden Ansprüche, **dadurch gekennzeichnet, dass** der Anteil des zumindest einen kationisch initiierenden Fotopolymerisationsinitiator an der Zusammensetzung insgesamt 1 Gew.% bis 5 Gew.%, vorzugsweise 2,5 Gew.%, beträgt.

17. Lötstopplack nach einem der vorhergehenden Ansprüche, **dadurch gekennzeichnet, dass** die Zusammensetzung weiterhin 0,5 Gew.% bis 5 Gew.%, vorzugsweise 1,5 Gew.%, Pigmente und/oder Farbstoffe umfasst.

18. Lötstopplack nach einem der vorhergehenden Ansprüche, **dadurch gekennzeichnet, dass** die Zusammensetzung weiterhin 1 Gew.% bis 5 Gew.%, vorzugsweise 1,5 Gew.%, Additive, wie z. B. Lackadditive wie beispielsweise Netz- und Dispergierhilfsmittel, Entschäumer oder Mittel zur Reduktion der Oberflächenspannung, und/oder Füllstoffe, umfasst.
